# EUROPÄISCHE PATENTSCHRIFT

(11) **EP 2 149 922 B1**
(45) Veröffentlichungstag und Bekanntmachung des Hinweises auf die Patenterteilung: **08.04.2015**
(21) Anmeldenummer: 09100303.8
(22) Anmeldetag: 28.05.2009
(51) Int. Cl.: H01L 41/083, H01L 41/047

(54) **Piezoaktor mit passiven Bereichen am Kopf und/oder Fuss**
Piezo actuator with passive areas at the head and / or foot
Piézoactionneur doté de zones passives à la tête et/ou au pied

(30) Priorität: 28.07.2008 DE 102008040769
(43) Veröffentlichungstag der Anmeldung: 03.02.2010
(73) Patentinhaber: Robert Bosch GmbH, 70442 Stuttgart (DE)
(72) Erfinder: Cromme, Peter, 96050 Bamberg (DE); Benes, Jan, 96047 Bamberg (DE)

(56) Entgegenhaltungen:
- EP-A2- 1 233 461
- WO-A1-01/91198
- WO-A1-2008/072767
- DE-A1- 19 856 201
- DE-A1-102004 038 194
- US-A1- 2007 084 034

## Beschreibung

### Stand der Technik

Die Erfindung betrifft einen Piezoaktor, bestehend aus übereinandergestapelten aktiven Piezoelementen und inaktiven bzw. passiven Bereichen am Kopf und Fuß des Piezoaktors, wobei die aktiven Piezoelemente aus jeweils mit Innenelektroden eingefassten Piezolagen bzw. Piezokeramiken gebildet sind, nach den gattungsgemäßen Merkmalen des Hauptanspruchs.

Ein solcher Piezoaktor kann beispielsweise in einem Piezoinjektor zur zeitpunkt- und mengengenauen Dosierung von Kraftstoff in einem Verbrennungsmotor eingesetzt werden. Dieser Piezoinjektor besteht im Wesentlichen aus einem Haltekörper und dem in dem Haltekörper angeordneten Piezoaktor mit den Piezoelementen.

Es ist an sich bekannt, dass der Piezoaktor so eingesetzt werden kann, dass unter Ausnutzung des sogenannten Piezoeffekts eine Steuerung des Nadelhubes eines Ventils oder dergleichen vorgenommen werden kann. Die Piezolagen der Piezoelemente sind aus einem Material mit einer geeigneten Kristallstruktur so aufgebaut, dass bei Anlage einer äußeren elektrischen Spannung eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor aus der DE 199 46 835 A1 bekannt, der zum Beispiel als Bestandteil eines Piezoinjektors in sogenannten Common Rail Einspritzsystemen (CR-Injektor) eingesetzt werden kann. Bei diesem Piezoaktor ist ebenfalls ein Stapel mehrerer elektrisch und mechanisch miteinander gekoppelter Piezoelemente als sogenannter Multilayer-Piezoaktor vorhanden, die über einen Aktorfuß und einen Aktorkopf unter Vorspannung zwischen zwei Anschlägen gehalten sind. Jede piezokeramische Piezolage der Piezoelemente ist auch hier in der Regel zwischen zwei Innenelektroden eingefasst, über die von außen eine elektrische Spannung angelegt werden kann. Aufgrund dieser elektrischen Spannung führen die Piezoelemente dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Bei dem zuvor erwähnten Piezoaktor wird zur Heranführung der unterschiedlichen Potenziale eine wechselseitige seitliche Kontaktierung der Innenelektroden über äußere Elektroden vorgenommen, bei der leitende Flächen auf jeweils einer Seitenfläche des Piezoaktors angebracht sind, die mit den jeweiligen Innenelektroden kontaktiert sind. Hier ist ein alternierend kontaktiertes Innenelektrodendesign mit einer weitgehend einheitlichen Schichtdicke über den gesamten aktiven Bereich vorgesehen.

An den aktiven Bereich der Piezoelemente schließt sich dann gegebenenfalls der passive Kopf- und/oder Fußbereich an, in dem die Innenelektroden in der Regel nicht alternierend kontaktiert sind, sondern in der Regel alle jeweils an eine gleiche Außenelektrode angeschlossen sind und damit auf dem gleichen Potenzial liegen, somit also einen passiven Bereich bilden. Die Isolationszone an den Außenelektroden sowie die Übergänge von aktivem zu passivem Bereich bilden hier eventuell potenzielle Schwachstellen solcher Multilayer-Piezoaktoren, da hier Bauteilbereiche mit großen Gradienten des elektrischen Feldes und damit mit relativ hohem Dehnungsgradienten vorhanden sind. Die daraus resultierenden mechanischen Spannungen führen in den Isolationszonen zu den Außenelektroden in der Regel zur Ausbildung von Polungsrissen, um den sogenannten Dehnungs-Mismatch zu kompensieren. Auch an den Übergängen vom aktiven zum passiven Kopf-/Fußbereich können dabei Rissbildungen zusätzlich induziert werden.

Weitere Piezoaktoren nach dem Stand der Technik sind aus WO 2008 / 072767 A1, EP 1 233 461 A, US 2007 / 0084034 A1, WO 01 / 97798 A1 und DE 198 56 201 A1 bekannt.

### Offenbarung der Erfindung

Die Erfindung geht von einem Piezoaktor mit einem Mehrschichtaufbau von Piezoelementen aus, die im aktiven Bereich jeweils aus zwischen Innenelektroden eingefassten Piezolagen bestehen wie durch Anspruch 1 definiert.

Ein solcher Piezoaktor kann zum Beispiel Bestandteil eines Piezoinjektors für ein Einspritzsystem für Kraftstoff bei einem Verbrennungsmotor sein. An die Innenelektroden des Piezoaktors wird zur in der Beschreibungseinleitung erläuterten Betätigung des Piezoaktors über eine wechselseitige seitliche Kontaktierung der Innenelektroden mittels Außenelektroden eine elektrische Spannung angelegt. Es sind auch aktive Bereiche an den kopf- und/oder fußseitigen Enden des Mehrschichtaufbaus der Piezoelemente vorhanden, die gemäß der Erfindung in vorteilhafter Weise einen graduellen Übergang der hinsichtlich eines elektrischen Feldes zwischen kontaktierten Innenelektroden wirksamen Schichtdicken der Piezoelemente von dem aktiven Bereich jeweils zum Kopf und/oder zum Fuß des Piezoaktors aufweisen.

Die zuvor genannten aktiven Bereiche tragen hier zur Bauteildehnung bei, indem sie mit einem elektrischen Feld beaufschlagt werden; die passiven Bereiche sind dagegen stets frei von einem elektrischen Feld und tragen nicht zur Dehnung bei. Die Bereiche mit einem graduellen Übergang sind ebenfalls aktiv, jedoch sind sie mit einem reduzierten elektrischen Feld aufgrund der erhöhten Schichtdicken beaufschlagt. Die graduelle Erhöhung der wirksamen Schichtdicken kann dabei in vorteilhafter Weise durch eine Einbringung nichtkontaktierter Metallisierungsschichten erfolgen, die bevorzugt aus dem gleichen Material gebildet sind.

Kern der Erfindung ist somit eine vorteilhafte Gestaltung des Übergangs zwischen dem aktiven Bereich und dem passiven Bereich am Kopf und/oder Fuß des Piezoaktors, die zur Robustheitssteigerung durch graduelle Übergänge der wirksamen Schichtdicke erreicht wird. Durch diesen derartig gestuften Übergang zwischen dem aktiven und den passiven Bereichen wird der eingangs erwähnte Mismatch in Dehnung und Materialeigenschaften, zum Beispiel ein anisotropes Gefüge im aktiven Bereich durch Polarisierung und ein isotropes Gefüge im passiven Bereich, stark abgeschwächt, was zu verminderter Rissneigung und gesteigerter Robustheit führt.

Durch eine reine Veränderung der Schichtdicke der Piezokeramik der Piezolagen könnte eine weitere Veränderung der Materialeigenschaften der Piezokeramik bewirkt werden, die daher rührt, dass durch die dadurch gebildeten größeren Abstände der Innenelektroden die Menge an eindiffundierten Innenelektrodenbestandteilen, zum Beispiel Silber (Ag) bei Silber-Palladium (Ag/Pd)-Innenelektroden, gegenüber dem voll-aktivem Bereich verringert wird. Diese geringen Mengen an eindiffundierten Innenelektroden-Elementen verändern jedoch unter Umständen das Material- und/oder Sinterverhalten und die Gefügeeigenschaften, was unter anderem zu inneren Spannungen und zu erhöhter Rissneigung führen kann und sich damit kontraproduktiv auf die Robustheitssteigerung des graduellen Übergangs auswirken würde.

Mit der Erfindung können solche Nachteile in vorteilhafter Weise vermieden werden, da hier ein Piezoaktordesign mit graduellem Übergang am Fuß und/oder Kopf dadurch realisiert wird, dass zumindest in den Bereichen der erhöhten Schichtdicken die entfallenen Innenelektroden durch nichtkontaktierte Metallisierungsschichten ersetzt werden, die vorzugsweise aus dem gleichen Material wie die Innenelektroden ausgeführt sind. Die Schichtdicke der Piezokeramik bleibt dadurch konstant, aber die hinsichtlich des elektrischen Feldes zwischen den kontaktierten Innenelektroden wirksame Schichtdicke kann verändert werden. Dadurch ist über die aktive Bauteillänge, einschließlich der Bereiche mit einer graduellen Erhöhung der Schichtdicken, ein homogener Dotierstoffanteil gegeben, was zu der zuvor erwähnten Robustheitssteigerung führt.

Die graduelle Erhöhung kann durch eine Aneinanderreihung von Bereichen unterschiedlicher wirksamer Schichtdicke mit jeweils einer sich zu dem äußeren Ende des Kopfes und/oder Fußes des Piezoaktors kontinuierlich sich erhöhenden Anzahl von eingebrachten nicht kontaktierten Metallisierungsschichten erfolgen.

Darüber hinaus können optional auch die nichtkontaktierten Metallisierungsschichten über die letzte kopf- bzw. fußseitige Innenelektroden des aktiven Bereichs hinaus fortgesetzt werden, um eine weitergehende Homogenisierung der Materialzusammensetzung und der Materialeigenschaften zu erzielen. Damit wird an der unmittelbaren Grenzfläche zwischen aktivem und passivem Bereich eine weitere Vergleichmäßigung der Materialeigenschaften erzielt und die Neigung zur Rissbildung im aktiven Bereich weiter herabgesetzt.

### Kurze Beschreibung der Zeichnungen

Ein Ausführungsbeispiel eines erfindungsgemäßen Aufbaus eines Piezoaktors wird anhand der Figuren der Zeichnung erläutert. Es zeigen:
Figur 1 einen schematischen Schnitt durch wesentliche Teile eines herkömmlichen Piezoaktors mit einem Mehrschichtaufbau von Piezolagen und Innenelektroden,
Figur 2 einen Detailschnitt durch eine Anordnung von Piezolagen mit einer Änderung der reinen Schichtdicken im Bereich des Kopfes und/oder des Fußes des Piezoaktors und
Figur 3 einen Schnitt durch einen erfindungsgemäßen Aufbau eines Piezoaktors mit einem graduellen Übergang der wirksamen Schichtdicken unter Einbringung von nichtkontaktierten Metallisierungsschichten.

### Ausführungsformen der Erfindung

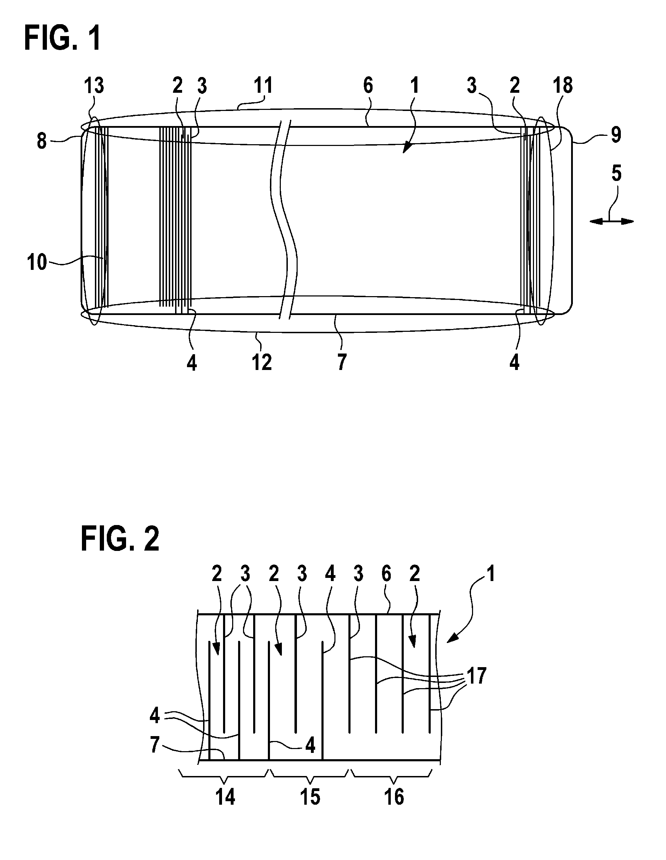

In Figur 1 ist zumindest teilweise zur Erläuterung des prinzipiellen Aufbaus ein herkömmlicher bekannter Piezoaktor 1 gezeigt, der Piezoelemente 2 mit Piezolagen oder -folien (Piezokeramik) aufweist, die unter Ausnutzung des Piezoeffekts bei Anlage einer elektrischen Spannung an Innenelektroden 3 und 4 eine mechanische Reaktion des Piezoaktors 1 in axialer Richtung (Pfeil 5) bewirken.

Die Innenelektroden 3 und 4 sind dabei in Richtung des Lagenaufbaus der Piezoelemente 2 abwechselnd mit einer unterschiedlichen Polarität einer elektrischen Spannung beaufschlagt. Dies wird durch eine wechselseitige seitliche Kontaktierung der Innenelektroden 3 und 4 über hier nicht näher gezeigte Außenelektroden 6 und 7 erreicht, über die die elektrische Spannung und Ladung zuführbar ist. An den Enden im Lagenaufbau der Piezoelemente 2 ist ein Kopf 8 und ein Fuß 9 vorhanden, über die der Piezoaktor 1 dann in ein Gehäuse, beispielsweise das Gehäuse eines Einspritzventils für Kraftfahrzeuge, bzw. eines sogenannten Piezoinjektors, zur Steuerung dieses Ventils eingebettet werden kann.

Am Kopf 8 ist nach der Figur 1 ein nicht wechselseitig kontaktierter passiver Bereich 10 gezeigt, der in gleicher Weise auch am Fuß 9 angeordnet ist. Es sind hier potenzielle Schwachstellen in mechanischer Hinsicht angedeutet, die beim Piezoaktor 1 durch Isolationszonen 11 und 12 an den Außenelektroden 6 und 7 sowie an jeweils einer Übergangszone 18 von aktivem zu passivem Bereich (hier im Bereich des Fußes 9 gezeigt) und am Ende des Piezoaktors 1 (Übergangszone 13, hier im Bereich des Kopfes 8 gezeigt) gebildet sind, da hier Bauteilbereiche mit unterschiedlich großen elektrischen Feldern und damit mit relativ hohem Dehnungsgradienten aneinandergrenzen, was zur Bildung von mechanischen Spannungen führt und Rissbildungen induzieren kann.

Aus Figur 2 ist eine herkömmliche Anordnung von Piezoelementen 2 mit Piezokeramik veränderter Schichtdicke gezeigt, wobei Bereiche mit einer erhöhten Schichtdicke durch Weglassen einzelner Innenelektroden erzeugt werden können. In einer Zone 14 ist mit den Innenelektroden 3 und 4 der aktiven Bereich des Piezoaktors 1 erkennbar, der mit einer Zone 15 mit einer vergrößerten Schichtdicke der Piezokeramik an eine Zone 16 des passiven Bereichs des Piezoaktors 1 angrenzt. In der Zone 16 des passiven Bereichs ist erkennbar, dass nur einseitig kontaktierte Innenelektroden 17, also ohne ein elektrischen Feld, vorhanden sind, zwischen denen sich Piezokeramiken mit ebenfalls vergrößerter Schichtdicke befinden. In der Zone 14 des aktiven Bereichs nach der Figur 2 kann hier beispielsweise eine elektrische Feldstärke von 2kV/mm, in der Zone 15 eine elektrische Feldstärke von 1kV/mm und in der Zone 16 des passiven Bereichs eine elektrische Feldstärke von 0kV/mm vorliegen.

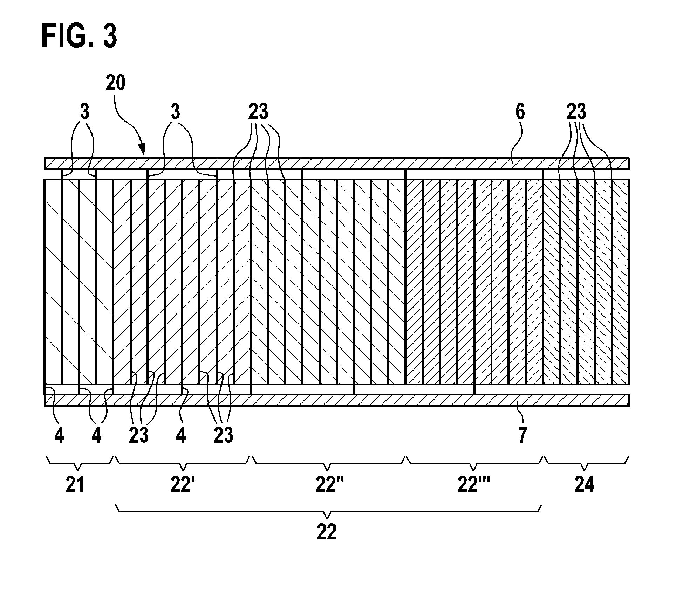

Figur 3 zeigt nunmehr einen erfindungsgemäßen Piezoaktor 20, bei dem in den Bereichen mit erhöhten wirksamen Schichtdicken die weggelassenen Innenelektroden durch unkontaktierte Metallisierungsschichten ersetzt sind. In einer Zone 21 entspricht der Aufbau der Innenelektroden 3 und 4 mit den Piezokeramiken dem bisherigen Aufbau. In einer Zone 22, die mit kontaktierten Innenelektroden 3 und 4 noch zum aktiven Bereich des Piezoaktors 20 gehört, sind jedoch nichtkontaktierte Metallisierungsschichten 23 aus dem Material der Innenelektroden 3 und 4 eingebracht, die beidseitig zu den Außenelektroden 6 und 7, also zu der positiven und der negativen Seite des Piezoaktors 20 denselben Isolationszonenabstand haben wie die hier jeweils einseitig kontaktierten Innenelektroden 3 und 4.

In der Figur 3 sind unterschiedliche Schraffierungen erkennbar, mit denen deutlich gemacht wird, dass sich die Anzahl von einer (Zone 22') zusätzlichen Metallisierungsschicht 23 über zwei (Zone 22") auf drei (Zone 22"') Metallisierungsschichten 23 erhöht. In einer Zone 24 des passiven Bereichs, hier am Fuß des Piezoaktors 20, befinden sich dann nur noch die nichtkontaktierten Metallisierungsschichten 23.

Der hier vorgeschlagene Piezoaktor 20 weist somit einen graduellen Übergang der wirksamen Schichtdicke bzw. des Abstandes der Innenelektroden 3 und 4 zwischen aktivem und dem passivem Bereich auf, wobei hier wegfallende Innenelektroden 3 oder 4 durch die nichtkontaktierten Metallisierungsschichten 23 aus dem gleichen Material wie die Innenelektroden 3 und 4 ersetzt werden. Auf die piezoelektrischen Eigenschaften der dadurch gebildeten Kondensatorschichten im graduellen Übergang hat dies einen vernachlässigbaren Einfluss, da die Dicke der Metallisierungsschicht 23 klein gegenüber der Schichtdicke der Piezokeramik gewählt ist. Dies beruht auf dem an sich bekannten Effekt, dass eine senkrecht in ein homogenes elektrisches Feld eingeschobene Metallplatte das elektrische Feld außerhalb dieser Platte, abgesehen von der Verringerung des Kondensatorplattenabstands, nicht beeinflusst.

Durch das Einbringen der gemäß der Figur 3 eingebrachten Metallisierungsschichten 23 und einer damit verbundenen Diffusion von Metallisierungsbestandteilen in die Piezokeramik beim Sinterprozess im sogenannten co-firing stellt sich in der fertig prozessierten Piezokeramik im Bereich des graduellen Übergangs der wirksamen Schichtdicken dieselbe Zusammensetzung ein wie im aktiven Bereich. Eine Veränderung der Gefügeeigenschaften und die damit verbundenen potenziellen negativen Auswirkungen auf die Prozesseigenschaften und die Bauteilrobustheit werden damit vermieden, die ansonsten bei einem reinen graduellen Übergang nach der Figur 2 durch den Entfall von Innenelektroden 3 und 4 durch eine lokal veränderte Zusammensetzung und veränderte Gefügeeigenschaften der Piezokeramik auftreten können.

## Patentansprüche

1. Piezoaktor mit einem Mehrschichtaufbau von Piezoelementen (2), die jeweils aus zwischen Innenelektroden (3,4) eingefassten Piezolagen bestehen, an die in einem aktiven Bereich über eine wechselseitige seitliche Kontaktierung der Innenelektroden (3,4) mittels Außenelektroden (6,7) eine elektrische Spannung anlegbar ist und mit mindestens einem Bereich an den kopf- und/oder fußseitigen Enden des Mehrschichtaufbaus der Piezoelemente (2), mit einer graduellen Erhöhung der hinsichtlich eines elektrischen Feldes zwischen kontaktierten Innenelektroden (3,4) wirksamen Schichtdicken der Piezoelemente (2) von dem aktiven Bereich jeweils zum Kopf (8) und/oder zum Fuß (9) des Piezoaktors (20), **dadurch gekennzeichnet, dass** die graduelle Erhöhung der hinsichtlich eines elektrischen Feldes zwischen kontaktierten Innenelektroden (3,4) wirksamen Schichtdicken durch eine Aneinanderreihung von Zonen (21, 22, 24) unterschiedlicher wirksamer Schichtdicke mit jeweils einer sich zu dem äußeren Ende des Kopfes (8) und/oder Fußes (9) des Piezoaktors (20) kontinuierlich sich erhöhenden Anzahl von eingebrachten, nicht kontaktierten Metallisierungsschichten (23) erfolgt.

2. Piezoaktor nach Anspruch 1, **dadurch gekennzeichnet, dass** die Abstände zwischen den nicht kontaktierten Metallisierungsschichten (23) sowie zwischen den nicht kontaktierten Metallisierungsschichten (23) und den benachbarten Innenelektroden (3,4) identisch sind zum Abstand der Innenelektroden im aktiven Bereich.

3. Piezoaktor nach Anspruch 1, **dadurch gekennzeichnet, dass** die nicht kontaktierten Metallisierungsschichten (23) und die Innenelektroden (3,4) aus dem gleichen Material gebildet sind.

4. Piezoaktor nach einem der vorhergehenden Ansprüche, **dadurch gekennzeichnet**, **dass** die Dicke der nicht kontaktierten Metallisierungsschichten (23) klein ist gegenüber der Dicke der Piezolagen.

5. Verwendung eines Piezoaktors nach einem der vorhergehenden Ansprüche, **dadurch gekennzeichnet, dass** der Piezoaktor (20) Bestandteil eines Einspritzsystems für Kraftstoff bei einem Verbrennungsmotor ist.

## Claims

1. Piezo actuator having a multi-layered structure of piezo elements (2) which are each composed of piezo layers which are bordered between internal electrodes (3, 4) and to which, in an active region, an electric voltage can be applied by forming lateral contact with the internal electrodes (3, 4) by means of external electrodes (6, 7) in a reciprocal fashion, and having at least one region at the head-side ends and/or foot-side ends of the multi-layered structure of the piezo elements (2) with a gradual increase in the layer thicknesses, effective with respect to an electrical field between internal electrodes (3, 4) with which contact is made, of the piezo elements (2) from the active region in each case to the head (8) and/or to the foot (9) of the piezo actuator (20), **characterized in that** the gradual increase in the layer thicknesses, effective with respect to an electrical field between internal electrodes (3, 4) with which contact is made, is carried out by juxtaposing zones (21, 22, 24) of different effective layer thicknesses, each with a number of introduced metallization layers (23), with which contact is not made, which increases continuously towards the outer end of the head (8) and/or foot (9) of the piezo actuator (20).

2. Piezo actuator according to Claim 1, **characterized in that** the distances between the metallization layers (23) with which contact is not made and the distances between metallization layers (23) with which contact is not made and the adjacent internal electrodes (3, 4) are identical to the distance between the internal electrodes in the active region.

3. Piezo actuator according to Claim 1, **characterized in that** the metallization layers (23) with which contact is not made and the internal electrodes (3, 4) are formed from the same material.

4. Piezo actuator according to one of the preceding claims, **characterized in that** the thickness of the metallization layers (23) with which contact is not made is less than the thickness of the piezo layers.

5. Use of a piezo actuator according to one of the preceding claims, **characterized in that** the piezo actuator (20) is a component of an injection system for fuel in an internal combustion engine.

## Revendications

1. Actionneur piézoélectrique comprenant une structure multicouche d'éléments piézoélectriques (2) qui se composent à chaque fois de couches piézoélectriques encastrées entre des électrodes intérieures (3, 4), au niveau desquelles, dans une région active, une tension électrique peut être appliquée par le biais d'un contact latéral alternatif des électrodes intérieures (3, 4) au moyen d'électrodes extérieures (6, 7), et comprenant au moins une région au niveau des extrémités de tête et/ou de base de la structure multicouche des éléments piézoélectriques (2) avec une augmentation graduelle des épaisseurs de couches des éléments piézoélectriques (2), actives en termes de champ électrique entre les électrodes intérieures mises en contact (3, 4), depuis la région active à chaque fois jusqu'à la tête (8) et/ou la base (9) de l'actionneur piézoélectrique (20), **caractérisé en ce que** l'augmentation graduelle des épaisseurs de couches actives en termes de champ électrique entre les électrodes intérieures mises en contact (3, 4) s'effectue par un alignement les unes contre les autres de zones (21, 22, 24) d'épaisseur de couche active différente, avec à chaque fois un nombre, augmentant en continu jusqu'à l'extrémité extérieure de la tête (8) et/ou de la base (9) de l'actionneur piézoélectrique (20), de couches de métallisation appliquées non mises en contact (23).

2. Actionneur piézoélectrique selon la revendication 1, **caractérisé en ce que** les intervalles entre les couches de métallisation non mises en contact (23) et entre les couches de métallisation non mises en contact (23) et les électrodes intérieures adjacentes (3, 4) sont identiques à l'intervalle entre les électrodes intérieures dans la région active.

3. Actionneur piézoélectrique selon la revendication 1, **caractérisé en ce que** les couches de métallisation non mises en contact (23) et les électrodes intérieures (3, 4) sont formées du même matériau.

4. Actionneur piézoélectrique selon l'une quelconque des revendications précédentes, **caractérisé en ce que** l'épaisseur des couches de métallisation non mises en contact (23) est petite par rapport à l'épaisseur des couches piézoélectriques.

5. Utilisation d'un actionneur piézoélectrique selon l'une quelconque des revendications précédentes, **caractérisée en ce que** l'actionneur piézoélectrique (20) fait partie d'un système d'injection de carburant dans un moteur à combustion interne.
